# EUROPEAN PATENT APPLICATION

(11) **EP 3 373 399 A1**
(43) Date of publication of application: **12.09.2018**
(21) Application number: 17196569.2
(22) Date of filing: 16.10.2017
(51) Int. Cl.: H01R 13/631, G06F 1/16, H01R 13/635, H01R 13/66, G06F 3/02

(54) **ELECTRONIC DEVICE**

(30) Priority: 08.03.2017 TW 106107515
(71) Applicant: Acer Incorporated, Taipei County 221 (TW)
(72) Inventor: Li, Guang-Zong, New Taipei City 221 (TW); Su, Hung-Jen, New Taipei City 221 (TW); Liu, Chih-Chun, New Taipei City 221 (TW); Wang, Yu-Shih, New Taipei City 221 (TW); Hsu, Chien-Yun, New Taipei City 221 (TW)
(74) Representative: Michalski Hüttermann & Partner Patentanwälte mbB

(57) **Abstract**

An electronic device is provided, including a first module (10) and a second module (20). The first module (10) includes a housing (H), a fixing member (310), a connector (350), and a flexible member (330). The housing (H) has a first hole (110). The fixing member (310) is fixed on the housing (H) and has a second hole (312) corresponding to the first hole (110). The connector (350) extends through the first (110) and second (312) holes. The flexible member (330) is disposed in the second hole (312) and surrounds the connector (350). The second module (20) includes a connecting base (500), wherein the connector (350) is detachably connected to the connecting base (500).

## Description

### CROSS REFERENCE TO RELATED APPLICATIONS

This application claims the benefit of Taiwan Patent Application No. 106107515, filed Mar. 8, 2017, the entirety of which is incorporated by reference herein.

### BACKGROUND OF THE INVENTION

### Field of the Invention

The application relates in general to an electronic device, and in particular, to an electronic device having a connector.

### Description of the Related Art

In recent years, touch functionality has become more and more important in electronic products. The screens of some notebook computers are detachable and can be used independently. However, in notebook computers that convert to tablets, the keyboard and the tablet are usually connected to each other with metal contacts. Therefore, the signals cannot be transmitted rapidly. When the metal contacts are replaced by the connectors, such as USB connectors, the connectors may break due to a collision, and it is hard to align the tablet with the keyboard.

### BRIEF SUMMARY OF INVENTION

To address the deficiencies of conventional products, an embodiment of the invention provides an electronic device including a first module and a second module. The first module includes a housing, a fixing member, a connector, and a flexible member. The housing has a first hole. The fixing member is fixed on the housing and has a second hole corresponding to the first hole. The connector extends through the first and second holes. The flexible member is disposed in the second hole and surrounds the connector. The second module includes a connecting base, wherein the connector is detachably connected to the connecting base.

In some embodiments, the flexible member contacts the inner wall of the second hole.

In some embodiments, the flexible member contacts the connector.

In some embodiments, the second hole has a first section and the second section, and the first section is disposed between the first hole and the second section, wherein the cross-sectional area of the first section is less than or the same as that of the first hole.

In some embodiments, the cross-sectional area of the second section exceeds that of the first section, and a gap is formed between the connector and the inner wall of the first section.

In some embodiments, the first module further comprises a first metal sheet disposed between the first section and the flexible member, and a gap is formed between the first metal sheet and the inner wall of the second section.

In some embodiments, the first module further comprises a circuit board and a soft member, and the connector is connected to the circuit board, wherein the circuit board is disposed between the connector and the soft member.

In some embodiments, the fixing member further comprises at least one guiding pillar, extending through the first hole.

In some embodiments, the distance between the top end of the guiding pillar and the first hole exceeds the distance between the top end of the connector and the first hole, and the thickness of the guiding pillar exceeds the thickness of the connector.

In some embodiments, the second module further comprises a case having a recess, and the connecting base is disposed in the recess, wherein when the connector is connected to the connecting base, the guiding pillar enters the recess and contacts the wall of the recess.

In some embodiments, the second module further comprises a rotary member pivotally connected to the case, wherein when the rotary member is in a first position, the rotary member covers the recess, wherein when the guiding pillar enters the recess, the guiding pillar pushes the rotary member and the rotary member rotates from the first position to a second position.

In some embodiments, when the rotary member is in a second position, the rotary member contacts the guiding pillar and the wall of the recess.

### BRIEF DESCRIPTION OF DRAWINGS

The invention can be more fully understood by reading the subsequent detailed description and examples with references made to the accompanying drawings, wherein:
Fig. 1 is a schematic diagram of an electronic device according to an embodiment of the invention;
Fig. 2A is a schematic diagram of an intermediate member according to an embodiment of the invention;
Fig. 2B is an exploded-view diagram of the intermediate member according to an embodiment of the invention;
Fig. 2C is a cross-sectional view along line A-A in Fig. 2A;
Fig. 2D is a partial top view of the intermediate member according to an embodiment of the invention;
Fig. 3 is a partial cross-sectional view of a second module according to an embodiment of the invention;
Fig. 4A is a schematic diagram that represents that a connector moves toward a connecting base according to an embodiment of the invention;
Fig. 4B is a schematic diagram of the connector and the connecting base connected to each other according to an embodiment of the invention;
Fig. 4C is a cross-sectional view the connector and the connecting base connected to each other according to an embodiment of the invention;
Fig. 5A is a schematic diagram that represents that a connector moves toward a connecting base according to another embodiment of the invention;
Fig. 5B is a schematic diagram of the connector and the connecting base connected to each other according to another embodiment of the invention; and
Fig. 6 is a schematic diagram that represents that a connector is separated from a connecting base according to an embodiment of the invention.

### DETAILED DESCRIPTION OF INVENTION

The making and using of the embodiments of the electronic device are discussed in detail below. It should be appreciated, however, that the embodiments provide many applicable inventive concepts that can be embodied in a wide variety of specific contexts. The specific embodiments discussed are merely illustrative of specific ways to make and use the embodiments, and do not limit the scope of the disclosure.

Unless defined otherwise, all technical and scientific terms used herein have the same meaning as commonly understood by one of ordinary skill in the art to which this invention belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise.

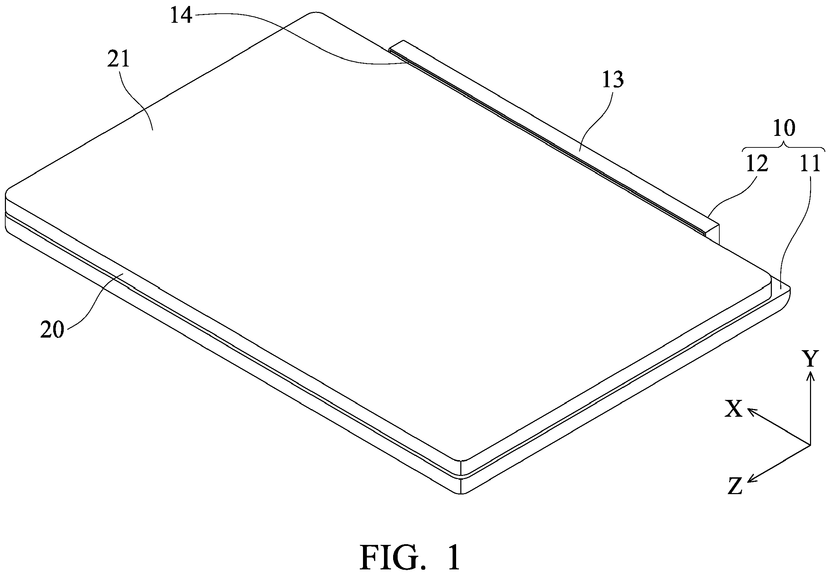

Referring to Fig. 1, an electronic device primarily comprises a first module 10 and a second module 20. The first module 10 comprises a main body 11 and an intermediate member 12, wherein the intermediate member 12 is pivotally connected to the main body 11, and the second module 20 is detachably connected to the intermediate member 12. When the second module 20 is connected to the intermediate member 12, the second module 20 and the intermediate member 12 can rotate relative to the main body 11.

As shown in Fig. 1, when the second module 20 is joined to the intermediate member 12, a first surface 13 of the intermediate member 12 is substantially aligned with a second surface 21 of the second module 20, and the second module 20 is attached to a connecting surface 14 of the intermediate member 12. There is no gap formed between the second module 20 and the intermediate member 12, so that an integrated appearance for the electronic device can be achieved. In this embodiment, the first module 10 can be an input module (for example, comprising a keyboard or a touchpad), and the second module 20 can be a display module (for example, a tablet or a flat display).

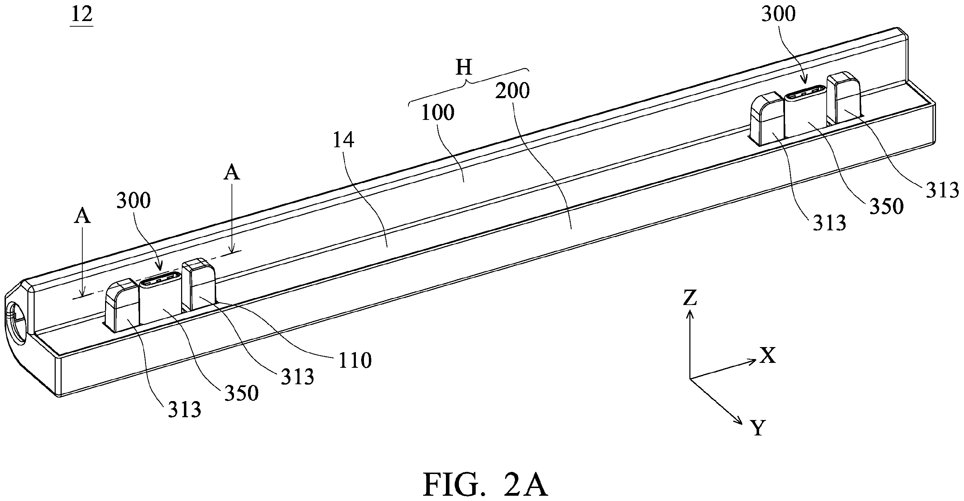

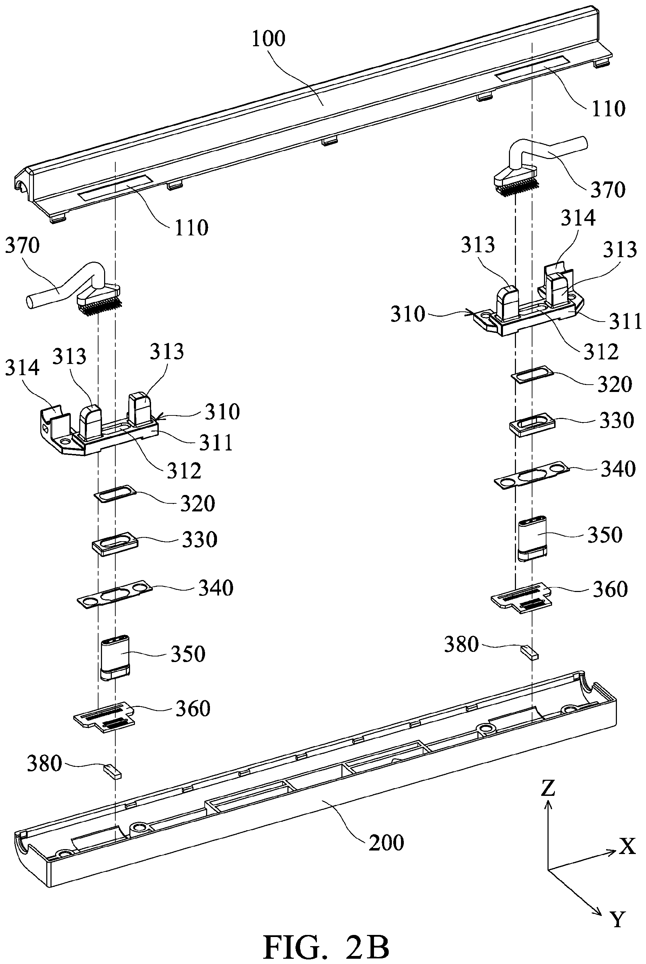

Referring to Figs. 2A and 2B, the intermediate member 12 comprises an upper cover 100, a lower cover 200, and at least one fixing mechanism 300. The upper cover 100 and the lower cover 200 can be assembled and form a hollow housing H, and the fixing mechanism 300 can be disposed in the hollow housing H. It should be noted that, the upper cover 100 substantially has a L-shaped structure, and at least one first hole 110 is formed on the connecting surface 14.

As shown in Figs. 2A and 2B, each of the fixing mechanisms 300 comprises a fixing member 310, a first metal sheet 320, a flexible member 330, a second metal sheet 340, a connector 350, a circuit board 360, a wire 370, and a soft member 380. In this embodiment, the fixing member 310 comprises a bottom 311 and two guiding pillars 313 connected with each other. The bottom 311 is fixed in the hollow housing H and has a second hole 312 corresponding to the first hole 110. Two guiding pillars 313 are respectively disposed on the opposite sides of the second hole 312 (i.e. the second hole 312 is disposed between two guiding pillars 313), extending through the first hole 110, and protruding from the connecting surface 14.

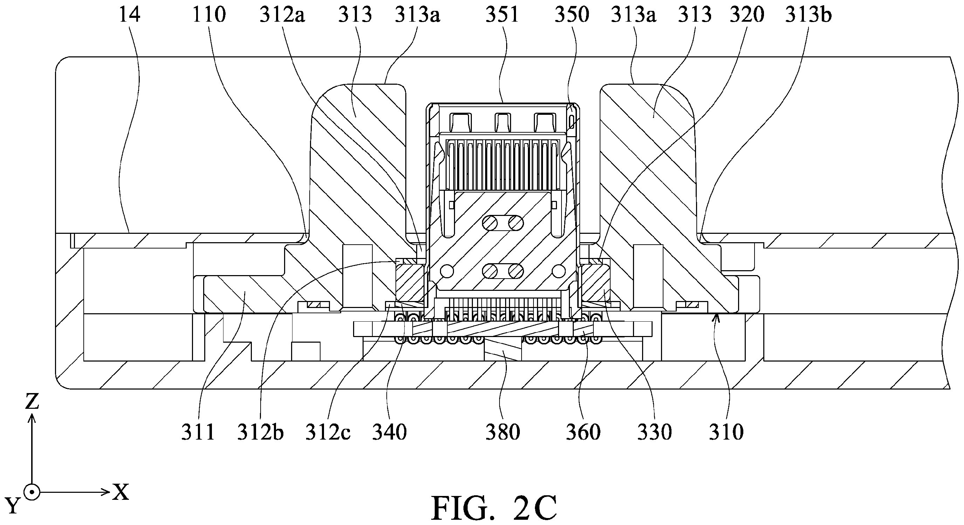

Fig. 2C is a cross-sectional view along line A-A in Fig. 2A. Referring to Figs. 2A-2C, the second hole 312 can be divided into a first section 312a, a second section 312b, and a third section 312c. The first section 312a is disposed between the first hole 110 and the second section 312b, and the second section 312b is disposed between the first section 312a and the third section 312c. The first metal sheet 320 and the flexible member 330 can be accommodated in the second section 312b of the second hole 312, and the second metal sheet 340 can be accommodated in the third section 312c. The first metal sheet 320 is disposed between the first section 312a and the flexible member 330, and the flexible member 330 is disposed between the first metal sheet 320 and the second metal sheet 340.

The connector 350 is connected to the circuit board 360. Since the position of the first hole 110 corresponds to that of the second hole 312, the connector 350 can extend through the second hole 312 and the first hole 110, protrude from the connecting surface 14 of the first module 10, and be disposed between two guiding pillars 313. The circuit board 360 and the soft member 380 are disposed below the fixing member 310, and the circuit board 360 is disposed between the connector 350 and the soft member 380. Furthermore, the wire 370 can be electrically connected to the circuit board 360 and other electronic members (not shown) in the first module 10.

As shown in Fig. 2B, in this embodiment, the fixing member 310 further comprises a fixing portion 314 for fixing and guiding the wire 370. Thus, the interference between the wire 370 and the aforementioned electronic members can be avoided.

As shown in Fig. 2C, the cross-sectional area of the first section 312a is less than or the same as that of the first hole 110, and the cross-sectional area of the second section 312b exceeds that of the first section 312a. Thus, the first metal sheet 320 and the flexible member 330 disposed in the second section 321b will not fall through the first hole 110 and the second hole 312. Moreover, the flexible member 300 surrounds the connector 350 and contacts the connector 350 and the inner wall of the second section 312b, so that the position of the connector 350 in the direction of Z-axis is fixed.

The cross-sectional area of the connector 350 is less than that of the first section 312a, and the cross-sectional area of the first metal sheet 320 is less than that of the second section 312b. In other words, a gap is formed between the connector 350 and the inner wall of the first section 312a, and another gap is also formed between the first metal 320 and the second section 312b. Similarly, another gap is formed between the second metal sheet 340 and the inner wall of the third section 312c.

In this embodiment, the width of the gap between the first metal sheet 320 and the inner wall of the second section 312b is substantially the same as the width of the gap between the connector 350 and the inner wall of the first section 312a, and substantially the same as the width of the gap between the second metal sheet 340 and the inner wall of the third section 312c.

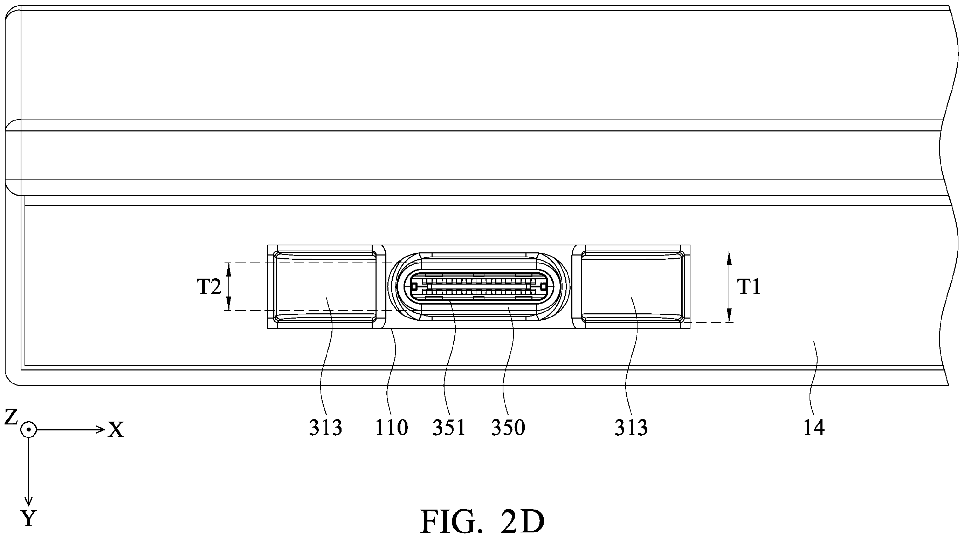

As shown in Figs. 2C and 2D, in this embodiment, the distance between the top end 313a of the guiding pillar 313 and the first hole 110 exceeds the distance between the top end 351 of the connector 350 and the first hole 110. The thickness T1 of the guiding pillar 313 exceeds the thickness T2 of the connector 350. Therefore, the breakage of the connector 350 due to the collision can be prevented. For example, the distance between the top end 313a of the guiding pillar 313 and the top end 351 of the connector 350 can be 0.5mm-2.0mm (such as 1mm), and the thickness T1 of the guiding pillar 313 is 1.0mm-2.0mm larger than the thickness T2 of the connector 350. Furthermore, the cross-sectional area of the guiding pillar 313 is tapered from the bottom end 313b to the top end 313a, such that the second module 20 can be easily joined to the guiding pillar 313.

The fixing member 310 or the guiding pillar 313 can comprise polyoxymethylene (POM), polyethylene (PE), or nylon, such that wear and tear between the guiding pillar 313 and the second module 20 due to friction can be reduced. The first and second metal sheets 320 and 340 can comprise aluminum, magnesium, or an alloy thereof, so as to reduce the weight of the electronic device. The flexible member 330 can comprise rubber or elastic fiber, and the connector 350 can comprise USB connector or lighting connector, for example. In this embodiment, the connector 350 is USB TYPE-C connector, therefore, a good transmission rate can be achieved.

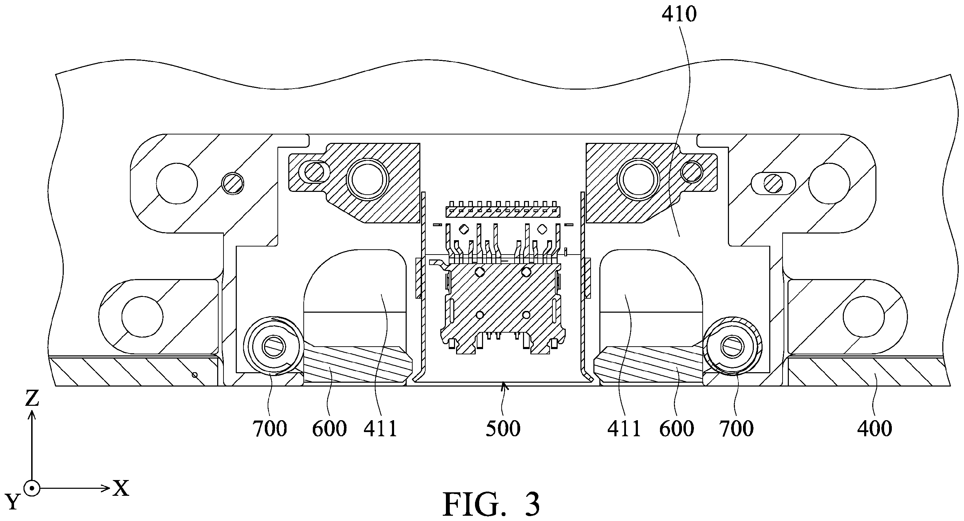

Referring to Fig. 3, the second module 20 comprises a case 400, a connecting base 500, at least one rotary member 600, and at least one elastic member 700. A recess 410 is formed on the case 410, and the connecting base 500 is disposed in the recess 410. A plurality of protrusions 410 are formed on the wall of the recess 410, wherein the shape and the position of the protrusions 411 are corresponded to that of the guiding pillars 313. The connecting port of the connecting base 500 is substantially disposed at the center of the opening of the recess 410, and the connecting base 500 does not protrude from the opening. The rotary member 600 is pivotally connected to the case 400, and the elastic member 700 is connected to the case 400 and the rotary member 600. When the first module 10 is separated from the second module 20, the rotary member 600 is in a first position and covers the recess 410. Thus, an integrated appearance for the second module 20 can be achieved. In this embodiment, the second module 20 comprises two rotary members 600 respectively disposed on the opposite sides of the connecting base 500. The elastic member 700 is a torsion spring, for example.

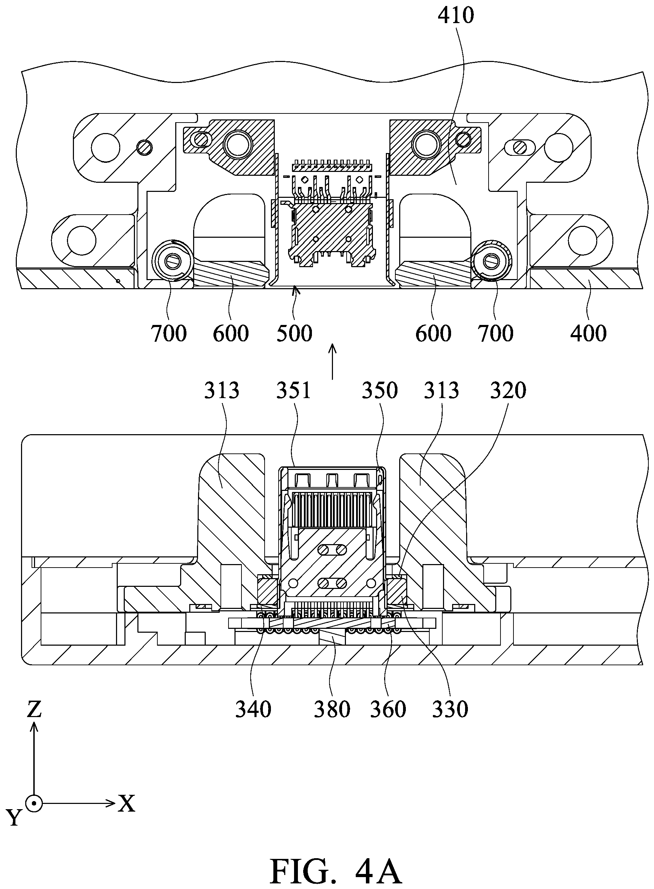

Referring to Figs. 4A-4C, when the first module 100 is connected to the second module 200, the connector 350 and the guiding pillars 313 can be inserted into the recess 410 of the case 400. The connector 350 is connected to the connecting base 500. Thus, the first module 100 and the second module 200 can transmit signals to each other via the connector 350, the connecting base 500, the circuit board 600, and the wire 700. The guiding pillar 313 pushes the rotary member 600, and the rotary member 600 rotates from the first position to a second position. It should be noted that, the width of the opening of the recess 410 exceeds the distance between the outer surfaces of two guiding pillars 313, so as to achieve convenient assembly.

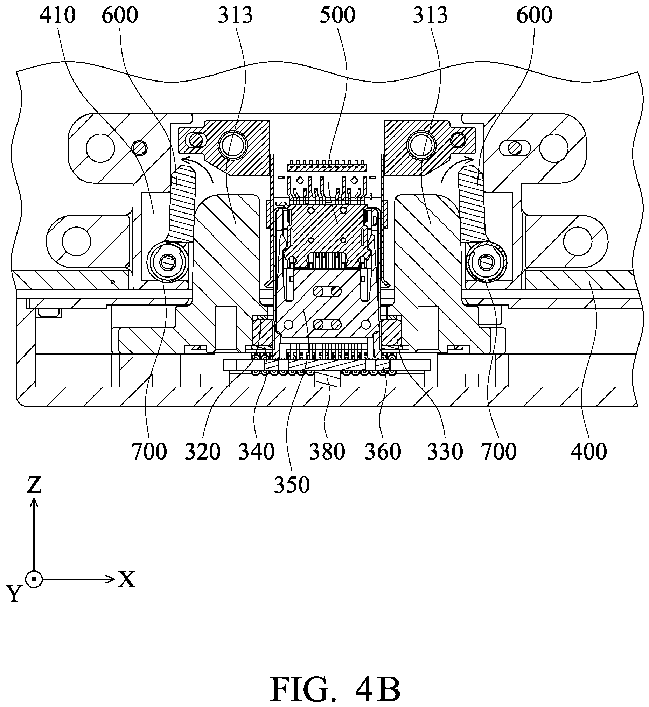

As shown in Fig. 4B, when the rotary member 600 is in the second position, the opposite sides of the rotary member 600 respectively contact the guiding pillars 313 and the wall of the recess 410. Thus, the first module 10 and the second module 20 in the direction of X-axis can be fixed.

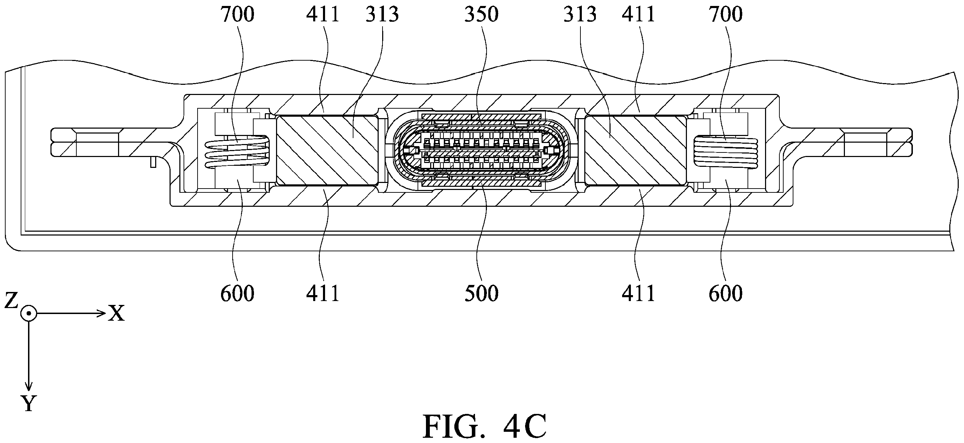

As shown in Fig. 4C, when the connector 350 is connected to the connecting base 500 and the guiding pillars 313 enter the recess 410, the protrusions 411 on the wall of the recess 410 contact the guiding pillars 313. Thus, the first module 10 and the second module 20 in the direction of Y-axis can be fixed.

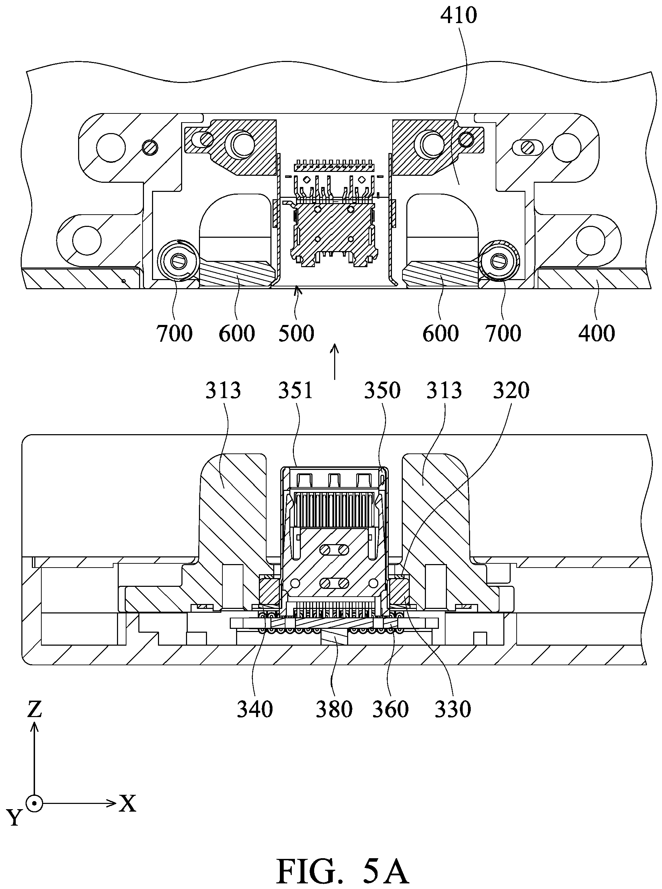

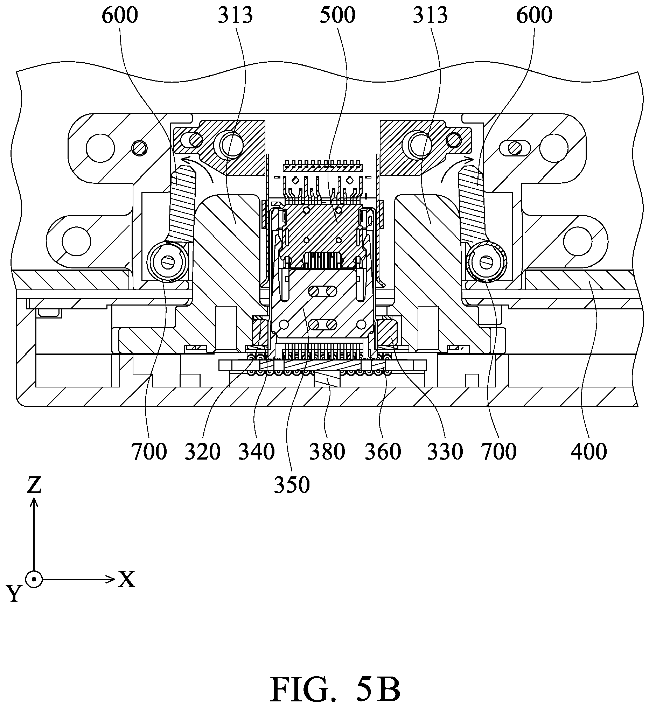

Specifically, as shown in Figs. 5A and 5B, since the flexible member 330 surrounds the connector 350, the flexible member 330 can slide and be compressed when the connector 350 is not aligned with the connecting base 500, and the connector 350 can move along the direction of X-axis and/or the direction of Y-axis. Therefore, the connector 350 can still connect to the connecting base 500. The flexible member 330 and the fixing member 310 may not slide due to a large frictional force. Since the electronic device has the first metal sheet 320 and the second metal sheet 340, the aforementioned disadvantage can be avoided.

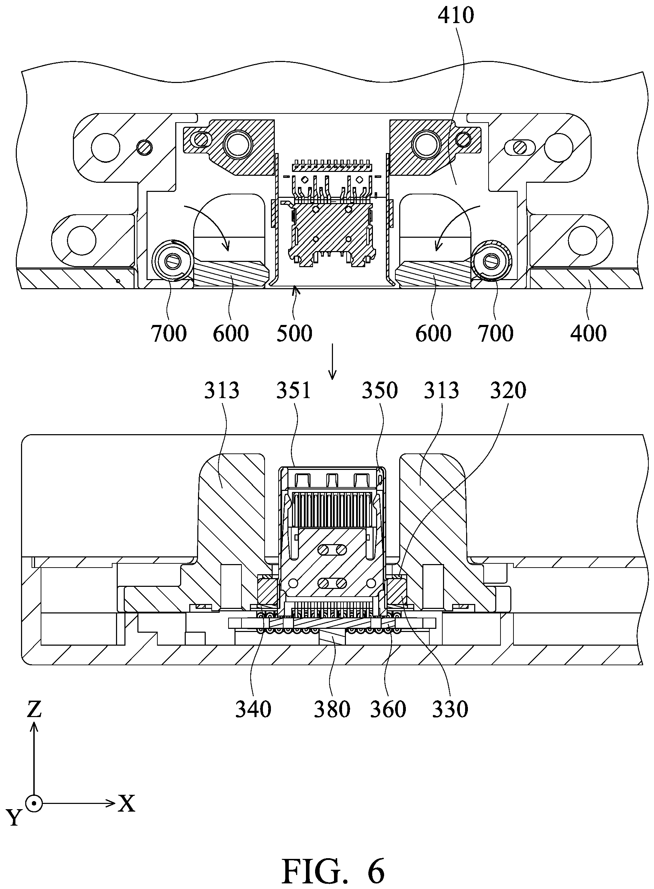

As shown in Fig. 6, when the connector 350 and the guiding pillars 313 leave the recess 410, the elastic member 700 provides an elastic force to push the rotary member 600, and the rotary member 600 rotates from the second position to the first position. The recess 410 can be covered by the rotary member 600 again.

In summary, an electronic device is provided, wherein the flexible member surrounds the connector, such that the connector can move by compressing the flexible member to match the connecting base which is not aligned with the connector. Furthermore, since the connector is disposed between the guiding pillars, breakage of the connector due to collision can be prevented.

Although some embodiments of the present disclosure and their advantages have been described in detail, it should be understood that various changes, substitutions and alterations can be made herein without departing from the spirit and scope of the disclosure as defined by the appended claims. For example, it will be readily understood by those skilled in the art that many of the features, functions, processes, and materials described herein may be varied while remaining within the scope of the present disclosure. Moreover, the scope of the present application is not intended to be limited to the particular embodiments of the process, machine, manufacture, compositions of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps. Moreover, the scope of the appended claims should be accorded the broadest interpretation so as to encompass all such modifications and similar arrangements.

While the invention has been described by way of example and in terms of preferred embodiment, it is to be understood that the invention is not limited thereto. On the contrary, it is intended to cover various modifications and similar arrangements (as would be apparent to those skilled in the art). Therefore, the scope of the appended claims should be accorded the broadest interpretation to encompass all such modifications and similar arrangements.

## Claims

1. An electronic device, comprising:
a first module, comprising:
a housing, having a first hole;
a fixing member, fixed on the housing and having a second hole, wherein the second hole corresponds to the first hole;
a connector, extending through the first hole and second hole; and
a flexible member, disposed in the second hole and surrounding the connector; and
a second module, comprising a connecting base, wherein the connector is detachably connected to the connecting base.

2. The electronic device as claimed in claim 1, wherein the flexible member contacts the inner wall of the second hole.

3. The electronic device as claimed in claim 1, wherein the flexible member contacts the connector.

4. The electronic device as claimed in claim 1, wherein the second hole has a first section and a second section, and the first section is disposed between the first hole and the second section, wherein the cross-sectional area of the first section is less than or the same as that of the first hole, the cross-sectional area of the second section exceeds that of the first section, and a gap is formed between the connector and the inner wall of the first section.

5. The electronic device as claimed in claim 1, wherein the second hole has a first section and a second section, the first section is disposed between the first hole and the second section, and the cross-sectional area of the first section is less than or the same as that of the first hole, wherein the first module further comprises a first metal sheet disposed between the first section and the flexible member, and a gap is formed between the first metal sheet and the inner wall of the second section.

6. The electronic device as claimed in claim 1, wherein the first module further comprises a circuit board and a soft member, and the connector is connected to the circuit board, wherein the circuit board is disposed between the connector and the soft member.

7. The electronic device as claimed in claim 1, wherein the fixing member further comprises at least one guiding pillar, extending through the first hole.

8. The electronic device as claimed in claim 7, wherein the distance between the top end of the guiding pillar and the first hole exceeds the distance between the top end of the connector and the first hole, and the thickness of the guiding pillar exceeds the thickness of the connector.

9. The electronic device as claimed in claim 7, wherein the second module further comprises a case having a recess, and the connecting base is disposed in the recess, wherein when the connector is connected to the connecting base, the guiding pillar enters the recess and contacts the wall of the recess.

10. The electronic device as claimed in claim 9, wherein the second module further comprises a rotary member pivotally connected to the case, wherein when the rotary member is in a first position, the rotary member covers the recess, wherein when the guiding pillar enters the recess, the guiding pillar pushes the rotary member and the rotary member rotates from the first position to a second position.

11. An electronic device, comprising:
a first module, comprising:
a housing, having a first hole;
a fixing member, fixed on the housing and having a second hole and two guiding pillars, wherein the second hole corresponds to the first hole and is disposed between the guiding pillars, and the guiding pillars extend through the first hole; and
a connector, extending through the first hole and second hole; and
a second module, comprising a connecting base and a case, wherein the case comprises a recess, and the connecting base is disposed in the recess, wherein when the connector is connected to the connecting base, the guiding pillars enter the recess and contact the wall of the recess.

12. The electronic device as claimed in claim 11, wherein the distance between the top end of each of the guiding pillars and the first hole exceeds the distance between the top end of the connector and the first hole, and the thickness of each of the guiding pillars exceeds the thickness of the connector.

13. The electronic device as claimed in claim 11, wherein the second module further comprises a rotary member pivotally connected to the case, wherein when the rotary member is in a first position, the rotary member covers the recess, wherein when the guiding pillars enter the recess, the guiding pillars push the rotary member and the rotary member rotates from the first position to a second position.

14. The electronic device as claimed in claim 11, wherein the first module further comprises a circuit board and a soft member, and the connector is connected to the circuit board, wherein the circuit board is disposed between the connector and the soft member.
